# EUROPEAN PATENT SPECIFICATION

(11) **EP 3 424 285 B1**
(45) Date of publication and mention of the grant of the patent: **26.10.2022**
(21) Application number: 17711802.3
(22) Date of filing: 03.03.2017
(51) Int. Cl.: H05K 7/16, H05K 7/18

(54) **LOCKABLE ELECTRONICS CABINET**
VERRIEGELBARER ELEKTRONIKSCHRANK
ARMOIRE ÉLECTRONIQUE VERROUILLABLE

(30) Priority: 04.03.2016 SE 1650291
(43) Date of publication of application: 09.01.2019
(73) Proprietor: Hans-Erik Johansson I Hagstad AB, 335 32 Gnosjö (SE)
(72) Inventor: JOHANSSON, Hans-Erik, 335 42 Gnosjö (SE)
(74) Representative: AWA Sweden AB
(86) International application number: PCT/SE2017/050199
(87) International publication number: WO 2017/151050

(56) References cited:
- US-A1- 2011 141 672
- US-A1- 2011 141 672
- US-B1- 6 318 824
- US-B1- 6 318 824

## Description

### Field of the invention

The present inventive concept relates to a lockable electronics cabinet and a method of assembling the same.

### Background

Cabinets or enclosures for permanent installation of electronics, designed to prevent break-in or unauthorized access, are known in the prior art. Various standards for break-in resistance exist, for example Swedish protection classes SN2 and SN3. Optionally, such cabinets may require electromagnetic shielding.

US6318824 discloses a hinged tracking system for attaching a door to a cabinet, allowing the door to translate away from the cabinet, as well as to rotate with respect to the cabinet.

US2011/0141672 discloses an LCD enclosure comprising a casing, a door for accessing an interior of the casing, and a hinge assembly configured to provide for rotational and linear movement of the door relative to the casing.

### Summary

It is an object of the present inventive concept to provide an improved solution for such a cabinet.

The invention is defined as set out in independent claim 1. Advantageous embodiments are set out in the dependent claims.

There is provided a lockable electronics cabinet, comprising a body and a door, where the door is arranged to be opened in a sequence of motions: first, a linear motion perpendicular to the plane of the door in its locked position, then, a rotational motion around a pivot axis. The linear motion occurs with the door being shifted from its original plane to another plane parallel to that original plane. The linear motion of the door away from the body of the cabinet frees the subsequent rotational motion from being constrained by the body of the cabinet, or by adjacent cabinets, allowing for the door during rotational motion to be opened 180 degrees or more. Furthermore, the linear motion allows for easy mating of a gasket with an edge, allowing for a tight seal between door and body.

This configuration also allows the pivot axis to extend through the bulk of the door, for example not running through joints or hinges external to the door leaf, as the linear motion gives space for the door to rotate around an axis internal to the door. This frees up space adjacent to the door, that otherwise for example would be taken up by hinges.

The door may be suspended with a plurality of rotational joints, the joints lining up along the pivot axis, where the joints are arranged to move along with the door during the linear motion. The term *rotational joint* should be understood as a joint allowing only rotational motion. Using separate rotational joints and translational joints, with the rotational joints simply following along with the linear motion, provides a mechanism that is more robust and that is easier to secure from break-in. In particular, the mechanism may carry a heavy door needed for, e.g., break-in resistance or electromagnetic shielding.

As an example, at least one (or alternatively all) of the rotational joints may be a bearing hinge.

To define the linear motion of the door, one of the body and the door may comprise one or more guiding members and the other one of the body and the door may comprise one or more engaging members. For example, the body may comprise one or more guiding members and the door may comprise one or more engaging members. During the linear motion phase, the engaging member engages with a respective guiding member, blocking rotation of the door by providing a linear path for the engaging member. This blocking of rotational motion may be achieved through the combined effect of the door engaging with rotational joints and the engaging member engaging with the guiding member, forming a lever arm between a joint and a guiding member. Suitable placing of this lever arm allows for a door that can be securely closed.

The guiding member may have a pre-defined opening through which the engaging member may escape. The engaging member thus being free from the guiding member at a suitable point of the linear motion, opening of the door may proceed with the rotational motion of the door around the pivot axis.

The guiding member and the joints may be located adjacent to a same lateral side of the cabinet. This will result in that the lever arm referred to above will be at an almost right angle with the face of the door. This saves space.

The door may comprise a lock, a bolt of which, with the door in closed and locked position, extends out of a lateral side of the door. The word *bolt* is to be interpreted as including hook bolts. Alternatively, if the bolt is not extending out of a lateral side of the door, the lock may at least be located adjacent to a lateral side of the door. This lateral side may be the same lateral side adjacent to which said one or more guiding members and the plurality of joints are located. This saves further space.

To drive the linear motion, the cabinet comprises a linear motion mechanism, which comprises a driving member, where the driving member is configured to run along a pre-determined path and to engage with a first guiding track resulting in the driving member driving the linear motion of the door with respect to the body of the cabinet. The pre-determined path may be defined by the driving member engaging with a second guiding track, but may also for example be realized by the driving member running on a rail. The second guiding track may be configured to be stationary during the linear motion and the first guiding track may be configured to move along with the linear motion.

The first guiding track has, with said driving member being located at a point along the pre-determined path, a tangent direction at its point of engagement with the driving member different from a tangent direction of the pre-determined path at the point where the driving member is located. This difference of tangent direction inflicts a transversal force component on the first guiding track, accomplishing the linear motion.

More specifically, in a preferred embodiment, the body may comprise the linear motion mechanism, which comprises a moving frame and a stationary frame. The stationary frame provides a guiding track and is connected to the main part of the cabinet body. The moving frame provides a different guiding track and is connected to the door. The driving member is configured to engage with both guiding tracks, where one of the guiding tracks has a slant or slope different from that of the other guiding track. Such a mechanism allows for smooth and secure operation of the door.

To engage with the guiding tracks, the driving member may for example be provided with one or more wheels on bearings. A lever may be connected to the driving member, allowing for a user to operate it. Alternatively, the driving member may be driven by a motor or actuator.

The ratio of transmission of a motion of the driving member to the linear motion may be adjusted according to need by changing the slope of either guiding track. Thus the direction of tangent may be varying at different positions along the guiding track. A high ratio of transmission may be desirable when the door is moving freely, while a low ratio of transmission may be desirable when there is an additional force to overcome, for example at a position when a groove of a gasket is to be mated with an edge. By an appropriate choice of slopes, the force felt when operating the driving member may be kept roughly constant during the whole linear motion. For example, the pre-determined path and/or one guiding track may be vertical and/or linear and the other one sloped. This has the advantage of less space being taken up lateral to the vertical guiding track. Even more specifically, the stationary guiding track may be vertical and/or linear and the moving guiding track may be sloped. This has the advantage of the driving member not moving in a horizontal direction. Thus, for example, a handle operating the driving member will exclusively move in a vertical direction.

The driving member may be supported so that any force applied to it does not have to work against the weight of the driving member. Such support may for example be provided by a gas spring. This makes the mechanism easier to operate.

The body may comprise an attenuating mechanism, where the engaging member of above is configured to engage with the attenuating mechanism during at least part of the rotational motion. Such an attenuating mechanism may avoid slamming of the door into the the body during rotational motion when closing the door.

Furthermore, the attenuating mechanism may be configured to guide the engaging member, during the rotational motion when closing the door, into the guiding member in preparation for the linear motion. The attenuating mechanism may for example be comprised of a U-shaped gripping member connected to a gas spring.

The cabinet may optionally be electromagnetically shielded.

The cabinet may comprise a gasket, defining a groove, and an edge, where the edge, with the door in closed position, mates with the groove forming an interface between the door and the body.

In case of electromagnetic shielding, the gasket may be a beryllium gasket, allowing for tight, electromagnetically shielded sealing between the door and the body.

The gasket may be located on the door, allowing for easy repairs or exchange of the gasket.

According to a second aspect of the disclosure, there is provided a lockable electronics cabinet, comprising a body, a frame and a door, where the body comprises a number of plates and is supported by the frame and where the frame is located outside an innermost layer of the plates. The frame thus not extending into the inside of the cabinet has the advantage of providing more space inside of the cabinet. Furthermore, installation of electronic equipment therein is simplified by the frame not being in the way during installation.

The frame may possibly extend exclusively along a top side, a bottom side, and one lateral side of the cabinet. Having the frame located on only one lateral side of the cabinet saves space.

The plates the body and the frame may possibly be composed of parts suitable for flat-pack transport, i.e., in packages having two dimensions considerably larger than a third one. This is possible if the body and the frame themselves consist of parts that fit into such packages and may be provided in a kit of such packages. This has the advantage of simplifying installation of the cabinet, as flat packages are easy to transport, even into cramped spaces.

The frame may possibly comprise one or more parts, extending along the bottom side one lateral side (thus being substantially L-shaped), or possibly along the whole or of part of the top side, thus substantially having a U-shape or a truncated U-shape. This provides a frame that is sturdy, the parts of which still fitting into a flat package.

The frame may further comprise a substantially U-shaped top part, in one or more pieces.

A locking mechanism and/or a door opening mechanism may possibly be located adjacent to the lateral side of the frame. This has the advantage of using the space in any case needed by the frame.

According to a third aspect of the disclosure, there is provided a method for assembling a lockable electronics cabinet, comprising the steps of providing frame and body parts in flat packages; and assembling the cabinet out of those parts at a site at which the cabinet is to be located.

### Brief description of the drawings

The above, as well as additional objects, features and advantages of the present inventive concept, will be better understood through the following illustrative and non-limiting detailed description of preferred embodiments, with reference to the appended drawings, where the same reference numerals will be used for similar elements, wherein:
Fig. 1a is an exploded perspective view of a cabinet.
Fig. 1b is a perspective view of the inside of a door of the cabinet.
Figs 1c-1f are perspective views of a cabinet at various stages of assembly.
Fig. 2a is a perspective view of three assembled cabinets in closed configuration.
Fig. 2b is a planar view of the same, seen from above.
Fig. 3a is a perspective view of three assembled cabinets, where the door of the middle cabinet has been brought forward in a linear motion from closed position.
Fig. 3b is a planar view of the same, seen from above.
Fig. 4a is a perspective view of three assembled cabinets, where the door of the middle cabinet has been partially opened in a rotational motion.
Fig. 4b is a planar view of the same, seen from above.
Fig. 5a is a perspective view of three assembled cabinets, where the door of the middle cabinet is fully opened.
Fig. 5b is a planar view of the same, seen from above.
Fig. 6a is a planar view, seen from above, of a cabinet where the door is fully opened.
Fig. 6b is a perspective view of the same, focusing on the attenuating mechanism.
Fig. 7a is a planar view, seen from above, of a cabinet where the door is being closed and is about to engage with the attenuating mechanism.
Fig. 7b is a perspective view of the same, focusing on the attenuating mechanism.
Fig. 8a is a planar view, seen from above, of a cabinet where the door is being closed and is engaging with the attenuating mechanism.
Fig. 8b is a perspective view of the same, focusing on the attenuating mechanism.
Fig. 9a is a planar view, seen from above, of a cabinet where the door is being closed and about to undergo linear motion.
Fig. 9b is a perspective view of the same, focusing on the attenuating mechanism and the rail.
Fig. 10a is a planar view, seen from above, of a cabinet where the door is being closed and undergoing linear motion.
Fig. 10b is a perspective view of the same, focusing on the guiding member.
Fig. 11a is a perspective view of the door about to be closed through linear motion, focusing on the operation of the linear motion mechanism.
Fig. 11b is a planar view of the same, seen from the side.
Fig. 12a is a perspective view of the door being closed through linear motion, the door just reaching the gasket, focusing on the operation of the linear motion mechanism.
Fig. 12b is a planar view of the same, seen from the side.
Fig. 13a is a perspective view of the door being closed through linear motion, the door penetrating the gasket, focusing on the operation of the linear motion mechanism.
Fig. 13b is a planar view of the same, seen from the side.
Fig. 14a is a perspective view of the door having being closed through linear motion, focusing on the operation of the linear motion mechanism.
Fig. 14b is a planar view of the same, seen from the side.
Figs 15a-15c are cross-sectional views showing the mating of the gasket of the door with the rest of the cabinet, at three different stages of motion.
Figs 16a-16b shows exemplary guiding tracks of the linear motion mechanism.

### Detailed description

A lockable electronics cabinet will now be described with reference to the drawings.

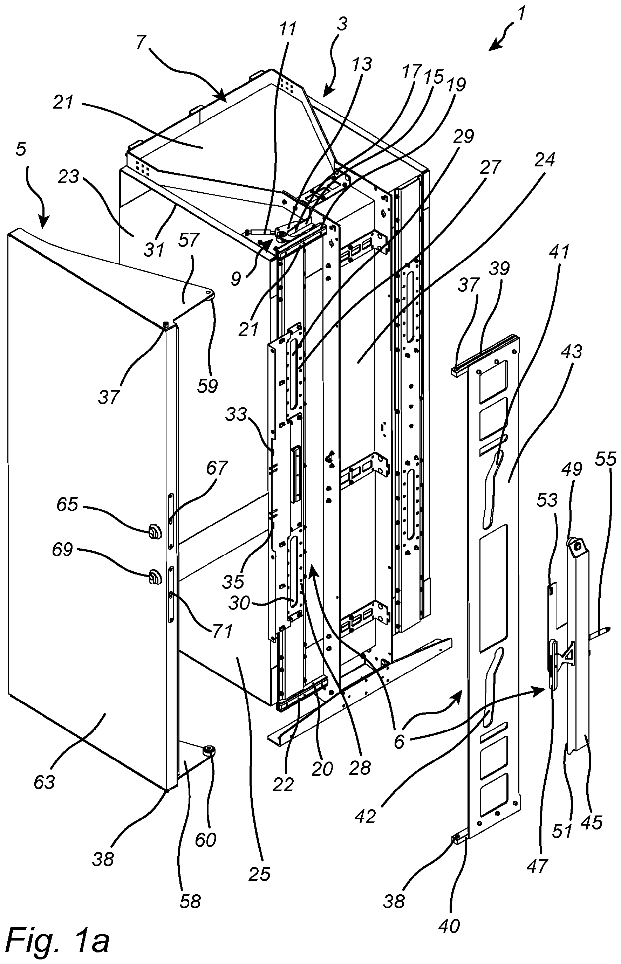

Fig. 1a shows an exploded view of a lockable electronics cabinet 1. The cabinet comprises a body 3 and a door 5. The door 5 is arranged to be opened in a sequence of motions, *viz.,* first a linear motion perpendicular to the plane of the door in locked position, then, a rotational motion around a pivot axis. Alternatively stated, it is arranged to be closed in a sequence of motions, *viz.,* first a rotational motion around a pivot axis, then a linear motion perpendicular to the plane of the door in locked position. The linear motion is driven by a linear motion mechanism 6. The rotational motion is facilitated by an attenuating mechanism 9.

As can be seen, the linear motion mechanism 6 uses space created by the frame 7 on the right side of the cabinet. In the same way, the attenuating mechanism uses similar space at the top of the cabinet.

The body 3 comprises a frame 7, a number of wall sections 21, 23, 24, 25, the linear motion mechanism 6 and the attenuating mechanism 9. The frame 7 carries the weight of the cabinet 1 and is located adjacent to the bottom side, right side, and top side of the cabinet. In alternative embodiment, the frame 7 may instead be located adjacent to the bottom side, the left side, and the top side of the cabinet.

The door 5 comprises a door leaf 63, top 57 and bottom 58 plates, providing stiffness to the door, and two locks 65, 69, each with a respective bolt 67, 71, preferably hook bolts. On each top 57 and bottom 58 plate, there is a respective small wheel 59, 60 on a bearing.

The linear motion mechanism 6 comprises an elongate driving member 45, a moving frame 43 in the form of a plate, and a stationary frame, in this particular embodiment consisting of two plates 27, 28. The moving frame 43 has an upper 41 and a lower 42 slanted guiding track, each with the same slant and shape. The two plates 27, 28 of the stationary frame are attached to the main part of the body 3, and each provides a respective upper stationary guiding track 29 and a lower stationary guiding track 30. Providing the tracks on two separate plates 27, 28 allows for making the plates thicker than other parts of the body, thereby making the tracks more durable.

The door 5 is attached to the moving frame through an upper joint in the form of a bearing hinge 37 and a lower joint in the form of a bearing hinge 38. These joints engage with the moving frame 43, and thus the body 3, at points located above and below the door 5. The pivot axis formed by the joints extends through the bulk of the door 5. The pivot axis is located inside of a perimeter formed by a front face of the door 5 and a side face of the door 5.

On the side of the moving frame, the joints 37, 38 attach to respective upper 39 and lower rails 40, which in turn attach to the main part of the moving frame 43. The moving frame 43 attached to upper 21 and lower 22 rails on the main part of the body 3, which in turn may slide through bearings against respective upper 19 and lower 20 U-shaped profiles attached to the body 3.

The purpose of the driving member 45 is to drive the linear motion of the door. It has an upper small wheel 49 carried on a bearing and a lower small wheel 51 carried on a bearing. The upper when 49 is configured to engage with the upper stationary guiding track 29 and the upper moving guiding track 41, while the lower wheel 51 is configured to engage with the lower stationary guiding track 30 and the lower moving guiding track 42. Furthermore, there is a gas spring 55 attached to the driving member for carrying its weight. This makes the driving member easier to operate, as any applied force will not have to counteract at least part of the weight of the mechanism. Furthermore, this avoids the driving member 47 spontaneously falling back into a lower position due to gravity. The other end of the gas spring 55 is attached to the main body 3. A hole 53 is provided into which the lock bolt 63 may extend when the cabinet is in locked position, thus preventing the driving member from moving.

The driving member may be operated by pulling a handle 47. The effect of the driving member then engaging with the stationary frame and the moving frame 43 is that the stationary frame and the door 5 undergoes linear motion in a direction perpendicular to a plane parallel to that of the face of the door in locked position, while remaining in a plane parallel to that of the face of the door in locked position. Thus, vertical motion of the handle 47 and the driving member 45 is converted into horizontal motion of the door 5. The transmission ratio between the vertical motion and the horizontal motion depends on the slopes, i.e., directions of tangent, of the guiding tracks. In principle, for this mechanism to work, the slant of the guiding tracks 29, 30 of the stationary frame and those 41, 42 of the moving frame only need to be different. However making the tracks of the stationary frame vertical makes them easier to fit in next to the frame 7. Making the guiding tracks of the moving frame slanted makes the driving member 45 and the handle 47 not move in a horizontal direction, which is convenient.

While not strictly necessary, the doubling of the mechanism - *i.e.,* having two wheels and two guiding tracks - as described improves the stability of the cabinet.

The driving member may be operated by a motor or by an actuator.

The body 3 further comprises an attenuating mechanism 8, comprised of a U-shaped gripping member 13 connected to a gas spring 11. The mechanism is arranged so the engaging member 59 of the door 5 is will engage with the gripping member 13 during part of the rotational motion. The attenuating mechanism 8 dampens the rotation, avoiding that the door 5 slams into the body 3. Furthermore, the gripping member 13 guides the engaging member 59 into the path provided by the guiding member 15. A second identical mechanism (not visible) may be located at the bottom of the cabinet.

The guiding member 17 provides a U-shaped path for the engaging member 59 of the door 5. During the linear motion, the wheel 59 is constrained by the two walls of that U-shaped path. This has the effect blocking the door 5 from rotating. The U-shaped path has an edge 15, defining an opening in the path. When the wheel 59 is located outside that edge 15, rotational motion is possible, as the wheel 59 is no longer constrained by the guiding member, the door then only engaging with the rotational joints 37, 38. This defines the transition point between the linear motion and the rotational motion.

A second identical guiding member (not visible) may be located at the bottom of the cabinet 1.

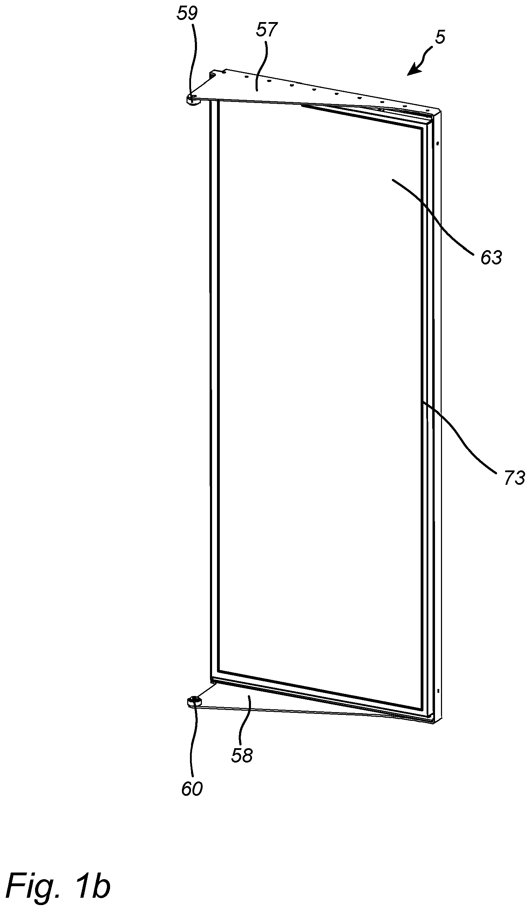

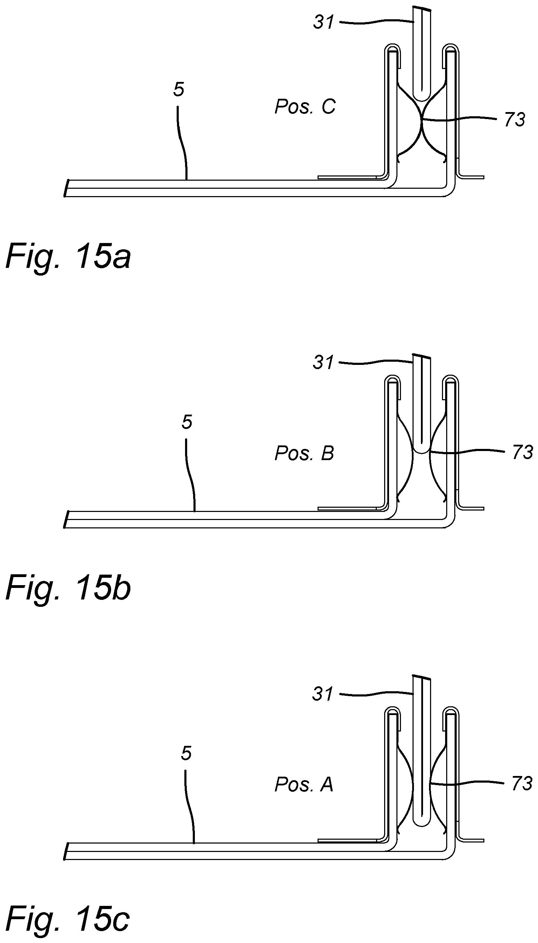

Fig. 1b shows the inside of a door 5 of the cabinet 1 (cf. Fig. 1a). Visible again are the top 57 and bottom 58 plates, each with a wheel 59, 60 on a bearing. Furthermore, there is a gasket 73 which runs along the perimeter of the inside of the door blade adjacent to the edge of the door 5. The gasket 73 may for example be made of rubber, or, if electromagnetic shielding is desired, from beryllium. The gasket 73 (cf. Figs 15a, 15b, and 15c) provides a groove to which the edge 31 (cf. Fig. 1a) of the body is to be mated. Having the gasket 73 located on the door 5 and the edge 31 located on the body 3, as opposed to having the edge 31 located on the door 5 and the gasket 73 located on the body 3, which also is possible, allows for easy maintenance, repairs, and replacement of the gasket 73.

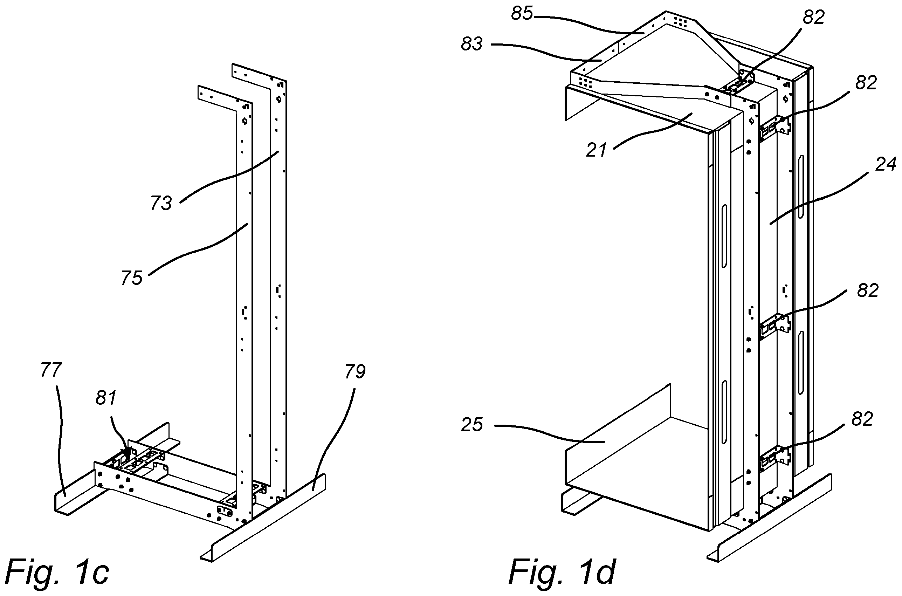

Figs 1c-1f show structural features of the frame and one possible sequence of assembly of the frame and plates of the cabinet body. Fig. 1c shows the cabinet at a first stage of assembly. At this stage, the frame comprises two straight L-profile floor sections 77, 79, and two flat, L-shaped middle sections 73, 75. As the middle sections extend partly along what will be the top of the cabinet, they may also be described as having a (truncated) U-shape. The middle sections 73, 75 are connected through a number of connecting segments 81 at their bases.

Fig. 1d shows the cabinet at a second stage of assembly. The frame has been completed by adding U-shaped top section 83, 85 to the top parts of the two middle sections. The top section 83, 85 may be made from more than one part or in one piece. More connecting segments 82 have been added between the two middle sections and between the two tips of the U-shaped top section. The frame finished frame only extends on one lateral side of the cabinet, forming a shape like a U laying on the side, as seen from the front of the cabinet. An, upper 21, a middle 24, and a lower 25 cover plate have been added, beginning to form the inside of the cabinet.

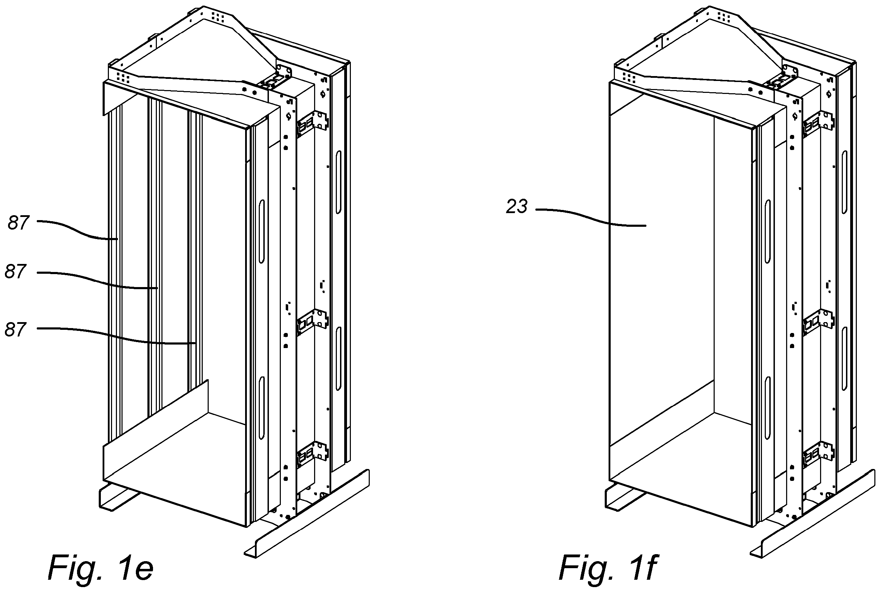

Fig. 1e shows an optional configuration wherein three supporting segments 87 have been added to the lateral side of the cabinet opposite to the two middle sections of the frame. These provide stiffness to the construction, but do not carry any substantial weight.

Fig. 1f shows a further cover plate 23 having been added to the lateral side of the cabinet opposite to the two middle sections of the frame. The fact that no parts of the frame extend into the inner side of the cabinet allows for a flexible space for installing electronics. The frame will not get in the way during installation.

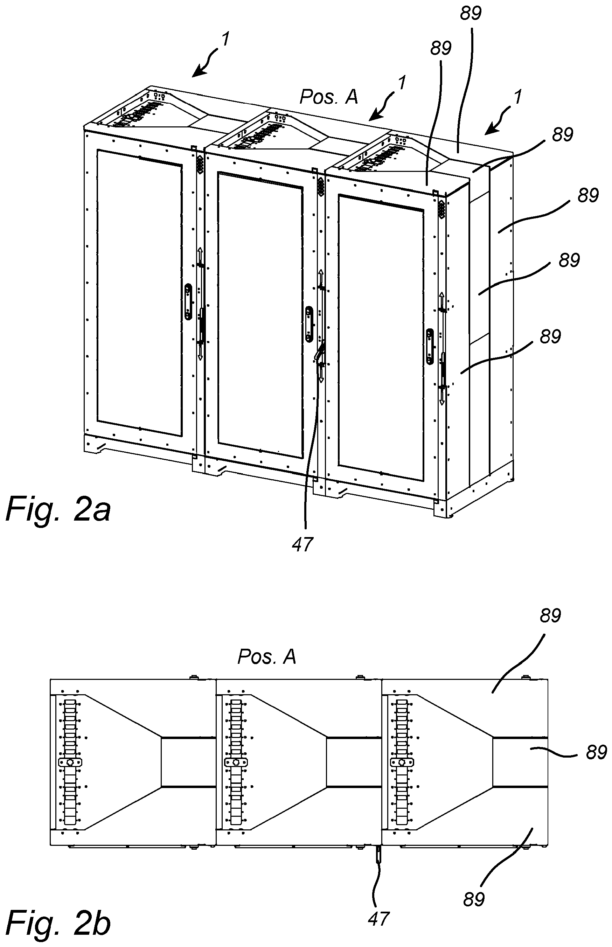

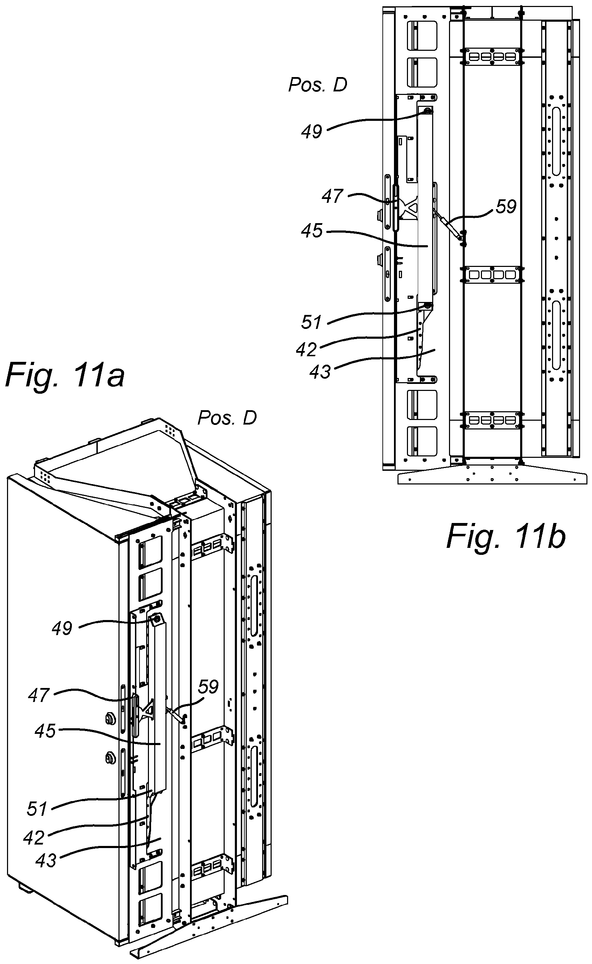

Finally, the mechanisms as shown in Figs 1a and 1b may be added to the cabinet (cf. Fig. 11a) and covered by external covering plates 89, as shown in Figs 2a and 2b, which show three assembled cabinets.

Other assembly sequences are equally possible. For example, the frame may be fully assembled before plates are added. As can be seen in Figs 1c-1f, the parts of the frame and the body, including the plates all have their extent along two dimensions significantly larger than their extent along a third dimension. This allows them to be delivered in flat packages that are easy to transport, simplifying installation at the intended site of the cabinet. Flat packages are here defined as packages that have two dimensions significantly larger than a third one. Significantly larger can here be seen as being at least twice as large, or even more preferably at least a third as large.

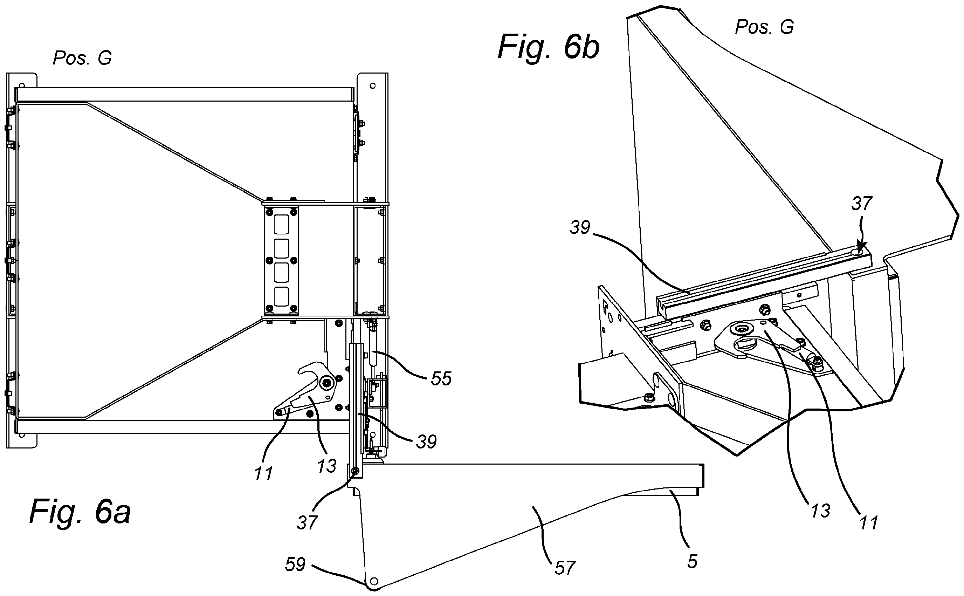

The cabinet is designed to be opened in a sequence of motions: first, a linear motion perpendicular to the plane of the door in its locked position, then, a rotational motion. Conversely, it is designed to be closed with the opposite sequence of motions: first, a rotational motion around a pivot axis, then a linear motion. This basic principle of operation of the cabinet door mechanism will now be described with reference to Figs 2a-4b. Thereafter, the specifics of the rotational motion will be described with reference to Figs 6a-10b. Finally, the specific of the linear motion will be described with reference to Figs 11a-16b.

To aid this description, it is useful to define a number of positions (or states) that the cabinet 1 and its mechanisms pass through during their motion, from a fully closed and locked configuration to a position where the door 5 is fully opened, or vice versa. These positions will then be referred to later on in the text and figures. Thus, define a position A with the door being fully closed and possibly locked and with the gasket mated with the edge, a position B where the linear motion has started and the edge is about to uncouple with the gasket, a position C where the edge is barely touching the gasket, a position D where the linear motion has reached its furthest from the starting position A and the rotational motion is about to start, a position E where the rotational motion has started and the attenuating mechanism is active, a position F where the attenuating mechanism has just let go of the door, and a position G where the door is opened a full 180 degrees.

Conversely, when closing the door, position F corresponds to where the attenuating mechanism is just about to start engaging with the door, position E where the attenuating mechanism is engaging with the door, position D where the rotational motion has finished and the linear motion is about to start, position C where the linear motion has reached the point where the edge is touching the gasket, position B where the edge has entered the grooved provided by the gasket and position A where the door is fully closed and possibly locked.

Figs 2a and 2b show three fully assembled cabinets 1 in closed position A. The handle 47 of the middle cabinet is being engaged - pulled on upwards - to start the linear motion.

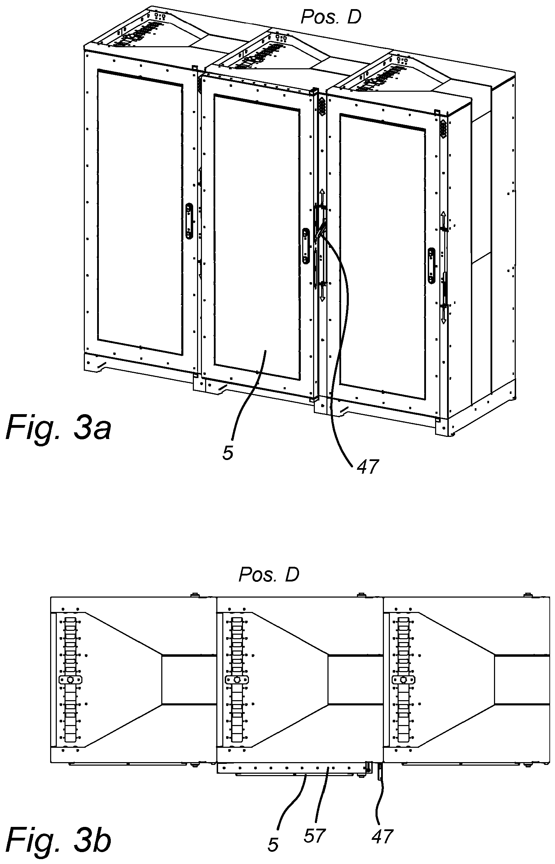

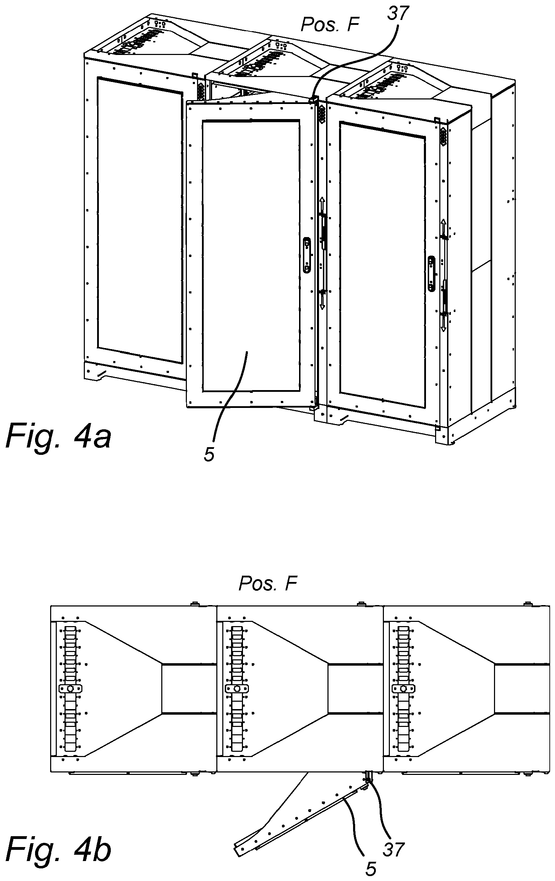

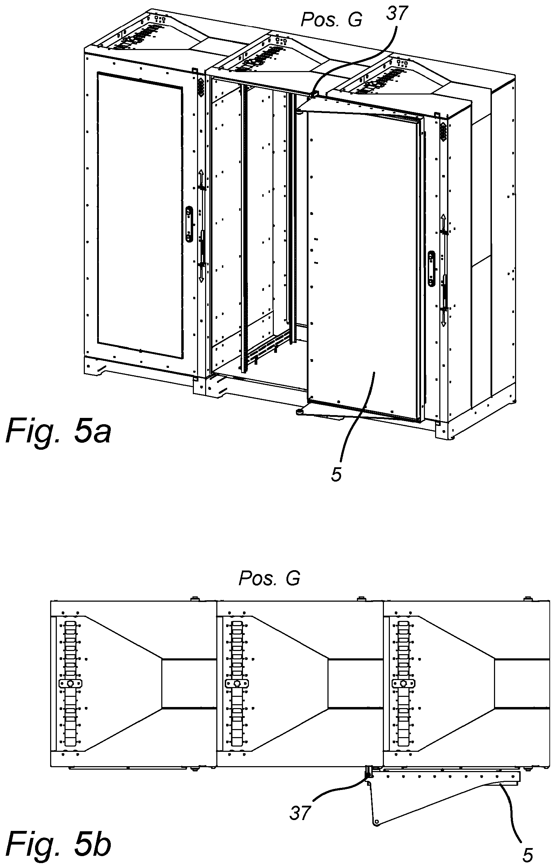

Figs 3a and 3b shows the middle cabinet having gone through the linear motion until position D, during which the handle 47 has been brought upwards. The left and right cabinets are still in closed position A. This applies equally in Figs 4a, 4b, 5a, and 5b. The door 5 of the middle cabinet can be seen protruding outside the plane formed by the two closed doors, its plane having been parallel shifted, while remains parallel to the plane of the other two doors and to its original plane in position A. The top plate 57 of the door 5 is visible in Fig. 3b.

Figs 4a and 4b show the middle door 5 in position F, in the middle of the rotational motion. Rotation occurs around the pivot axis defined by the joint 37 and its lower counterpart.

Finally, Figs 5a and 5b show the door of the cabinet in fully open position G. The door can be opened 180 degrees due to the fact that its pivot axis defined by the joint 37 and its lower counterpart has been brought in their entirety outside the plane formed by the other closed cabinets by the linear motion. Thus, rotational motion of the door is not constrained by the body of the cabinet or by the adjacent cabinets.

The following paragraphs will describe the operation of the cabinet with focus on the rotational motion, providing the example of closing the door starting at position G and finishing at position A, with reference to Figs 6a-10b.

Figs 6a and 6b show a cabinet with the door 5 in fully open position G. The top plates are not present to allow the attenuating mechanism, comprising the gripping member 13 and gas spring 11, to be visible. Visible are also the top plate 57, the gas spring 55 of the driving member, the joint 37, the wheel/engaging member 59, and the rail 39. A user may now start closing the door by pulling on it to start a closing rotational motion.

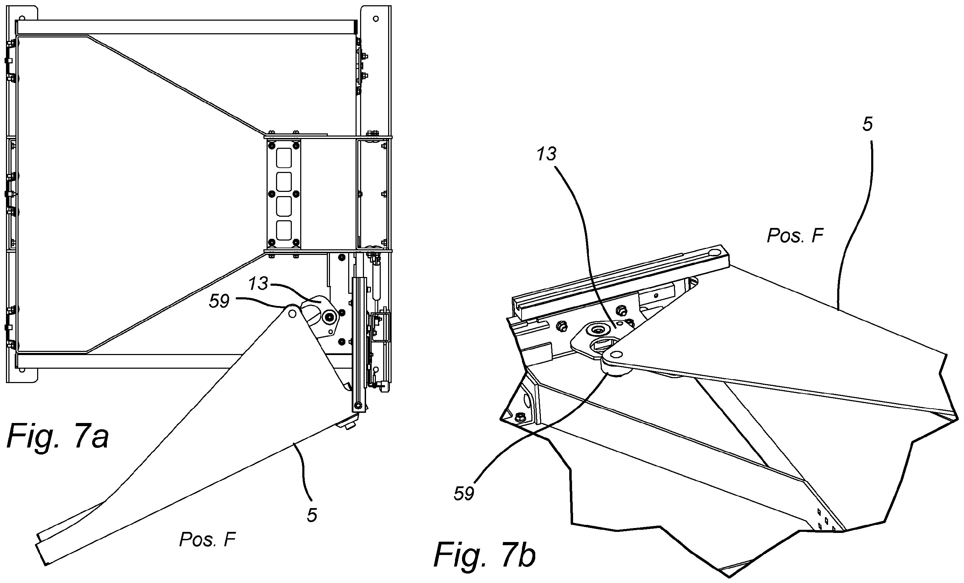

Figs 7a and 7b show the cabinet in position F, the rotational motion thus just having been brought to a position where the gripping member 13 just about to start engaging with the engaging member 59 of the door. As can be seen, if the rotational motion is brought further, the wheel 59 will start to push on the gripping member 13, placing itself in the U shape of the same. The rotational motion is thus dampened by the gas spring 11 (conf. Figs 6a and 6b), preventing the door 5 from slamming into the body. Furthermore, the gripping member 13 will help lead the wheel 59 to a point where it can engage with the guiding member 15 (cf. Fig. 1a) for the subsequent linear motion.

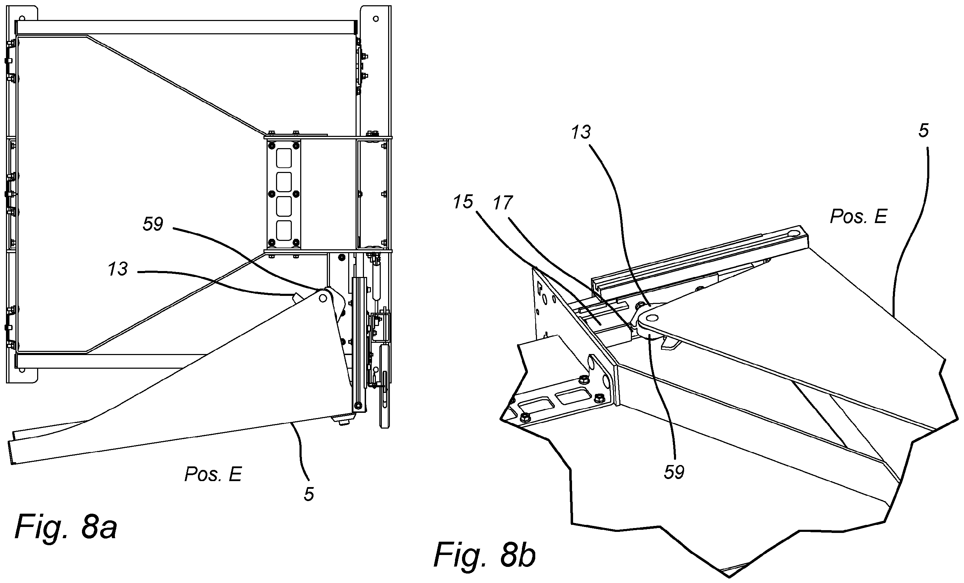

Figs 8a and 8b show the cabinet in position E, where the gripping member 13 of the attenuating mechanism is engaging with the door 5. The wheel 59 is approaching the edge 17 of the guiding member 15.

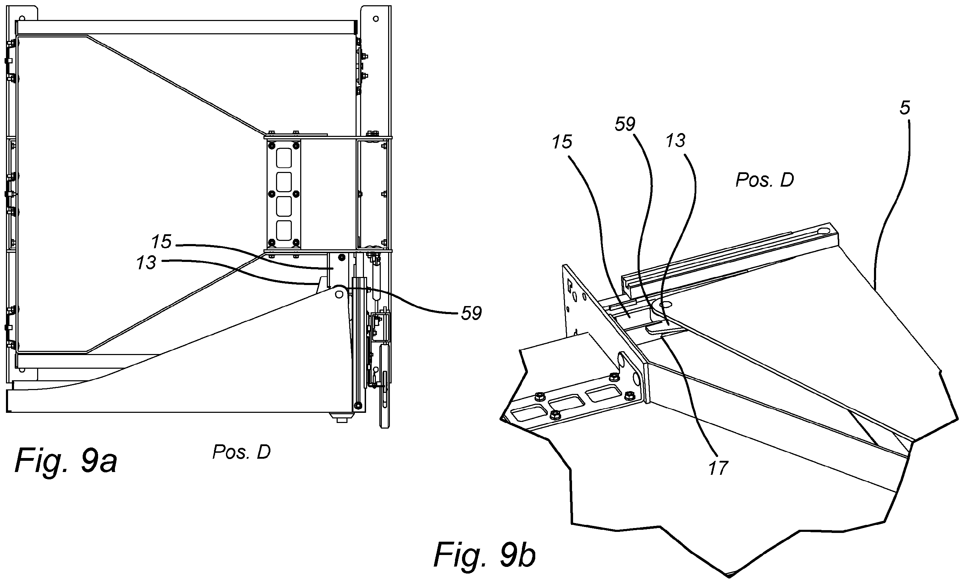

Figs 9a and 9b show the cabinet in position D, where the rotational motion has finished and the engaging member 59 has reached the start 17 (cf. Figs 8a and 8b) of the path provided by the guiding member 15. One side of the U-shape of the gripping member 13 engages with the outside of the guiding member 15, preventing further rotational motion of the gripping member and of the engaging member, positioning the engaging member right at the start 17 of the path of the guiding member 15. The user may then initiate the linear motion by pulling the lever 47 (cf. Fig. 1a). The engaging member 59 follows the path provided by the guiding member 15.

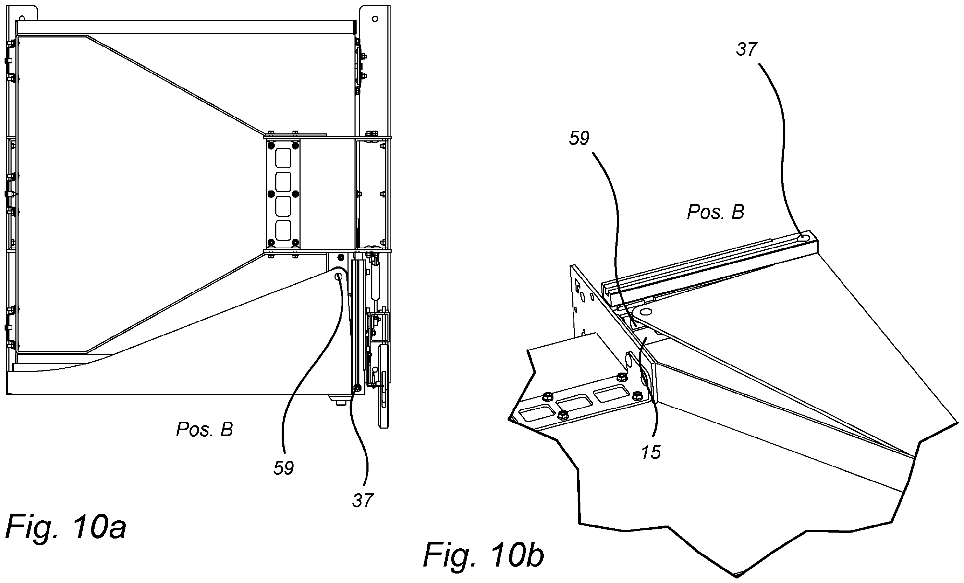

Finally, Figs 10a and 10b show the cabinet in position B, undergoing linear motion. The wheel 59 engaging with the guiding member 15 provides a rotation-blocking lever arm with respect to the pivot axis and joint 37 that is almost at a right angle to the plane of the door.

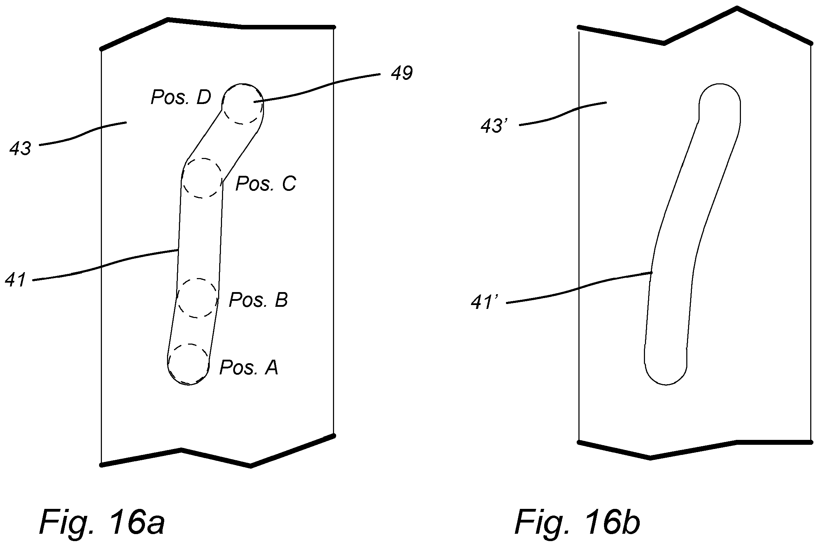

The following paragraphs will describe the operation of the linear motion mechanism, providing an example of the linear motion part of the operation of closing the door, starting at position D and finishing at position A, with reference to Figs 11a-15b. A detailed view of one of the guiding tracks 42 of the moving frame 43 is shown in Fig. 16a, where also the location of the wheel 49 in positions A, B, C, and D are indicated with dashed circles.

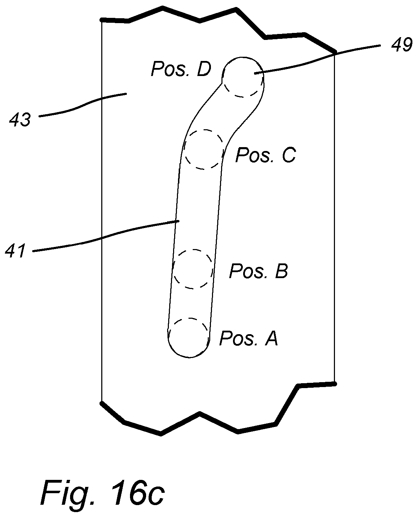

A detailed view of an alternative guiding track is shown in Fig. 16c.

Figs 11a and 11b show the cabinet in position D. Side plates of the cabinet are for illustration not shown so as to reveal the linear motion mechanism. The gas spring 59 is visible. The wheels 49, 51 of the driving member 45 are positioned at the tops of their respective guiding tracks 41, 42, of the moving frame 43. The handle 47 may now be pulled to initiate the linear motion. The wheels 49, 51 of the driving member 45 then engage with the sloped guiding tracks 41, 42 of the moving frame 43, pushing the moving frame 43 and the door 5 to which it is attached towards the body of the cabinet. The guiding track at this position (Fig. 16a and Fig. 16c) has a large deviation from the vertical, providing a high transmission ratio between the vertical motion of the handle 47 and the driving member 45 and the horizontal linear motion of the door.

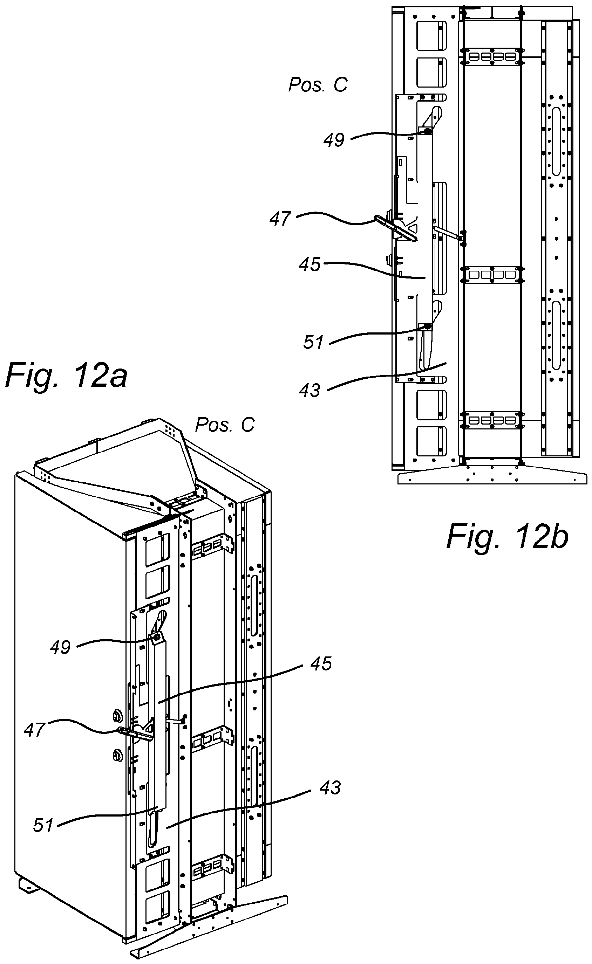

Figs 12a and 12b show the cabinet in position C, while Fig. 15a shows a cross-sectional view of the edge 31 and the gasket 73 on the door 5 (only partially shown) with the cabinet in the same position C. The edge 31 is just barely touching the gasket 73. The slope of the guiding track 41, 42 (Fig. 16a) now changes into one less deviating from the vertical, providing a lower transmission ratio between ratio between the vertical motion of the handle 47 and the driving member 45 and the horizontal linear motion of the door, as a larger force is now required for the edge 31 to penetrate the groove of the gasket 73, pushing its two sides apart. For example, a 70 mm motion of the lever 47 may here result in a 3 mm motion of the edge 31 into the gasket 73.

As can be seen in Fig. 16c, the transition between the larger slope between postions D and C and a smaller slope between positions C and B may be made smooth, i.e., there being a transition region with continuously varying slope, which ensure smooth operation of the mechanism.

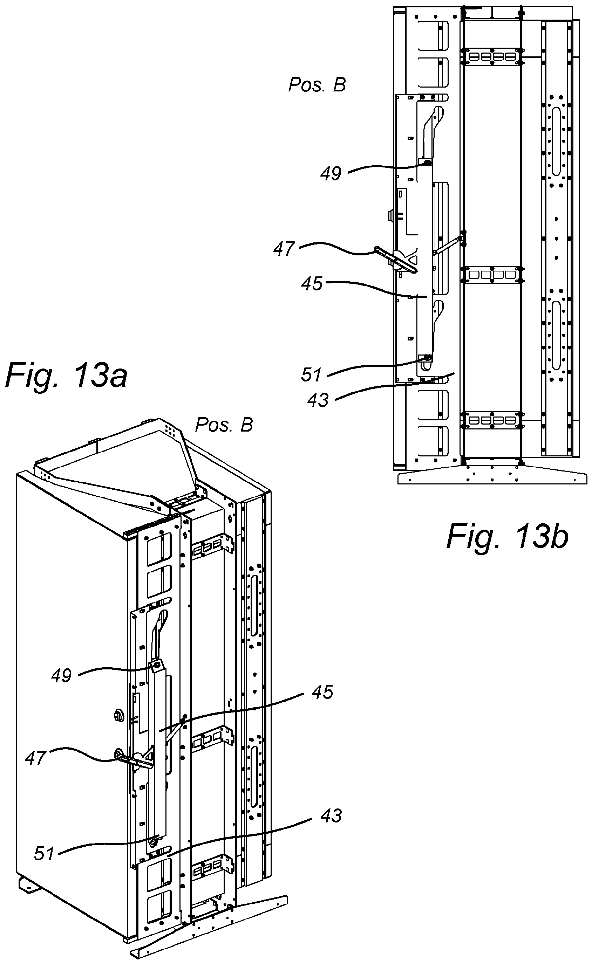

Figs 13a and 13b show the cabinet in position B, while Fig. 15b shows a cross-sectional view of the gasket and the edge with the cabinet in the same position B. As can be seen in Fig. 16a, the slope of the guiding track is again slightly more deviating from the vertical, as the required force again diminishes as the groove has been penetrated by the edge. Alternatively, as can be seen in Fig. 16c, the slope may continue to be the same between postions B and A as it was between positions C and B.

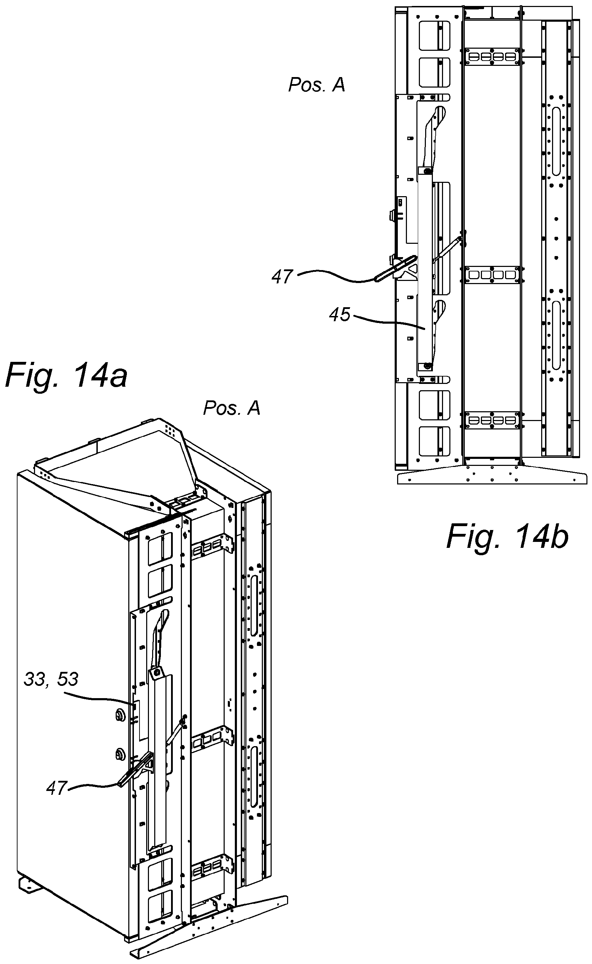

Finally, Figs 14a and 14b show the cabinet in position A. The lock holes 33, 53 of the stationary frame and of the driving member line up to allow the bolts of the locks to extend through both. With the driving member 45 having been locked that way, even if engaging the lever 47 as shown, the driving member may not be moved. Fig. 15c shows a cross sectional view of the edge and the gasket in the same position A.

Figs 15a, 15b and 15c show cross-sectional views of part of the door 5, the gasket 73 and the edge 31. As is evident from Figs 15a, 15b and 15c, the linear motion in the plane of the edge 31 facilitates the mating of the groove formed by the gasket 73 and the edge 31, which otherwise would be hard to perform, forming a tight seal between them.

Fig. 16b shows the guiding track 41' in an alternative embodiment, where less force is needed to penetrate the gasket, suitable for use with a rubber gasket rather than a beryllium one.

In Fig. 16a, the local slope of the guiding track 41 at the end points of the linear motion - position A and in position D - is vertical. This prevents linear motion of the door 5 as long as the driving member 49 or handle 47 is not operated upon.

As can be seen when comparing Figs 16a and 16b, the slope of the guiding track may either vary continuously along the track, or exhibit sudden jumps, all according to needed force. For example, the slope may be designed for a person or machine operating the driving member 45 to experience a roughly constant force throughout the linear motion.

Thus, the guiding track 41 may be divided into a number of segments having different slope. Transition regions between these segments may have continuously varying slope to ensure smooth operation of the mechanism. There may be a first region D having a vertical slope, intended for keeping the driving member 49 in place. There may be a second region D-C having a relatively large slope, i.e., with a higher deviation from the vertical, for quickly transporting the door where a relatively small force is needed. There may be a third region C-B with a comparatively small slope, i.e., small deviation from the vertical, where a large force is needed, e.g., to penetrate a gasket. Finally, there may be a fourth region B-A with a slope between those of the second region and the third region one the gasket is penetrated and less force is needed than in the third region. All of these regions are optional and may be combined according to need.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

The following summarizes more examples.

To drive the linear motion, the cabinet may comprise a linear motion mechanism, which comprises a driving member, where the driving member is configured to engage with a slanted guiding track resulting in linear motion of the door with respect to the body of the cabinet. More specifically, in a preferred example, the body may comprise the linear motion mechanism, which comprises a moving frame and a stationary frame. The stationary frame provides a guiding track and is connected to the main part of the cabinet body. The moving frame provides a different guiding track and is connected to the door. The driving member is configured to engage with both guiding tracks, where one of the guiding tracks has a slant or slope different from that of the other guiding track. Such a mechanism allows for smooth and secure operation of the door.

To engage with the guiding tracks, the driving member may for example be provided with one or more wheels on bearings. A lever may be connected to the driving member, allowing for a user to operate it. Alternatively, the driving member may be driven by a motor or actuator.

The ratio of transmission of a motion of the driving member to the linear motion may be adjusted according to need by changing the slope of either guiding track. Thus the slant may be varying at different positions along the guiding track. A high ratio of transmission may be desirable when the door is moving freely, while a low ratio of transmission may be desirable when there is an additional force to overcome, for example at a position when a groove of a gasket is to be mated with an edge. By an appropriate choice of slopes, the force felt when operating the driving member may be kept roughly constant during the whole linear motion. For example, one guiding track may be vertical and the other one sloped. This has the advantage of less space being taken up lateral to the vertical guiding track. Even more specifically, the stationary guiding track may be vertical and the moving guiding track may be sloped. This has the advantage of the driving member not moving in a horizontal direction. Thus, for example, a handle operating the driving member will exclusively move in a vertical direction.

The driving member may be supported so that any force applied to it does not have to work against the weight of the driving member. Such support may for example be provided by a gas spring. This makes the mechanism easier to operate.

## Claims

1. A lockable electronics cabinet (1), comprising a body (3) and a door (5), said door (5) being arranged to be opened in a sequence of motions, comprising, first, a linear motion perpendicular to the plane of the door and then, a rotational motion around a pivot axis, wherein said cabinet (1) comprises a linear motion mechanism (6), said linear motion mechanism (6) comprising a moving frame connected to said door (5), a stationary frame connected to a main part of said body (3), a first guiding track (41, 32) provided by one of said moving frame and said stationary frame, and a guiding arrangement (29, 30) provided by the other of said moving frame and said stationary frame,
**characterized by**
said first guiding track (41, 32) and said guiding arrangement (29, 30) thereby being movable with respect to each other in direction of said linear motion, said linear motion mechanism (6) further comprising a driving member (45, 49, 51) configured to drive said linear motion by running along a pre-determined path defined by the driving member engaging with the guiding arrangement (29, 30) while simultaneously engaging with said first guiding track (41, 42), wherein, with a first location along said pre-determined path corresponding to a second location along said first guiding track such that said driving member (45, 49, 51), while running along said pre-determined path (29, 30) through said first location, engages with said first guiding track (41, 42) at said second location, a tangent direction of said first pre-determined path (29, 30) at said first location is different from a tangent direction of said first guiding track (41, 42) at said second location.

2. The lockable electronics cabinet (1) of claim 1, said guiding arrangement comprising a second guiding track (29, 30).

3. The lockable electronics cabinet (1) of claim 2, said second guiding track (29, 30) being configured to be stationary during said linear motion.

4. The lockable electronics cabinet (1) of any one of claims 1-3, said first guiding track (41, 42) being configured to move along with said linear motion.

5. The lockable electronics cabinet (1) of any one of claims 2-4, said body comprising said linear motion mechanism (6), said stationary frame (27, 28) providing said second guiding track (29, 30) and being connected to a main part of said body (3), said moving frame (43) providing said first guiding track (41, 42) and being connected to said door (5).

6. The lockable electronics cabinet (1) of any one of claims 2-5, wherein one of said first guiding track (29, 30) and said second guiding track (41, 42) is linear.

7. The lockable electronics cabinet (1) of any one of claims 2-5, wherein said second guiding track (29, 30) is linear.

8. The lockable electronics cabinet (1) of claims 1-7, wherein said tangent direction of said first guiding track or said tangent direction of said pre-determined path is different at different positions along said first guiding track (41, 42, 41') or said pre-determined path.

9. The lockable electronics cabinet (1) of any one of the preceding claims, wherein said door (5) is suspended with a plurality of rotational joints (37, 38), said joints (37, 38) lining up along said pivot axis, said joints (37, 38) being arranged to move along with said door (37, 38) during said linear motion.

10. The lockable electronics cabinet (1) of any one of the preceding claims, wherein one of said body (3) and said door (5) comprises one or more guiding members (15) and the other one of said body (3) and said door (5) comprises one or more engaging members (59, 60), each engaging member (59) engaging with a respective guiding member (15) of said one or more guiding members (15), said guiding member (15) blocking rotation of said door (5) and providing a path for said engaging member (59), said path defining said linear motion of said door (5).

11. The lockable electronics cabinet (1) of claim 10, wherein said one or more guiding members (15) and said plurality of joints (37, 38) are located adjacent to a same lateral side of said cabinet (1).

12. The lockable electronics cabinet (1) of any one of claims 10-11, wherein said body (3) comprises an attenuating mechanism (9), said engaging member (59) being configured to engage with said attenuating mechanism (9) during at least part of said rotational motion, wherein said attenuating mechanism (9) is configured to guide said engaging member (59, 60) into said guiding member (15).

13. The lockable electronics cabinet (1) of any one the preceding claims, wherein the electronics cabinet (1) is electromagnetically shielded.

14. The lockable electronics cabinet (1) of any one the preceding claims, comprising a gasket (73) defining a groove, and an edge (31), wherein said edge (31), with said door (5) in closed position (A), mates with said guiding track forming an interface between said door (5) and said body (3), wherein said gasket (73) preferably is a beryllium gasket, and wherein said gasket (73) preferably is located on said door (5).

## Patentansprüche

1. Verschließbarer Elektronikschrank (1), der einen Körper (3) und eine Tür (5) aufweist, wobei die Tür (5) derart angeordnet ist, durch eine Reihe an Bewegungen geöffnet zu werden, umfassend erst eine lineare Bewegung senkrecht zu der Ebene der Tür und dann eine Drehbewegung um eine Schwenkachse, wobei der Schrank (1) einen linearen Bewegungsmechanismus (6) aufweist, wobei der lineare Bewegungsmechanismus (6) einen Bewegungsrahmen, der mit der Tür (5) verbunden ist, einen stationären Rahmen, der mit einem Hauptteil des Körpers (3) verbunden ist, eine erste Führungsspur (41, 32), die durch den Bewegungsrahmen oder den stationären Rahmen bereitgestellt wird, und eine Führungsanordnung (29, 30), die durch den anderen von den Bewegungsrahmen bzw. stationären Rahmen bereitgestellt wird, aufweist, **dadurch gekennzeichnet, dass**
die erste Führungsspur (41, 32) und die Führungsanordnung (29, 30) dadurch bezüglich einander in der Richtung der linearen Bewegung bewegbar sind, wobei der lineare Bewegungsmechanismus (6) ferner ein Antriebselement (45, 49, 51) aufweist, das dazu ausgelegt ist, die lineare Bewegung durch Laufen entlang eines vorbestimmten Pfads, der durch Eingreifen des Antriebselements mit der Führungsanordnung (29, 30) bestimmt wird, bei gleichzeitigem Eingreifen mit der ersten Führungsspur (41, 42), anzutreiben, wobei eine erste Stelle entlang des vorbestimmten Pfads einer zweiten Stelle entlang der ersten Führungsspur entspricht, derart, dass das Antriebselement (45, 49, 51) beim Laufen entlang des vorbestimmten Pfads (29, 30) durch die erste Stelle mit der ersten Führungsspur (41, 42) an der zweiten Stelle eingreift, wobei sich eine Tangentenrichtung des ersten vorbestimmten Pfads (29, 30) an der ersten Stelle von einer Tangentenrichtung der ersten Führungsspur (41, 42) an der zweiten Stelle unterscheidet.

2. Verschließbarer Elektronikschrank (1) nach Anspruch 1, wobei die Führungsanordnung eine zweite Führungsspur (29, 30) aufweist.

3. Verschließbarer Elektronikschrank (1) nach Anspruch 2, wobei die zweite Führungsspur (29, 30) dazu ausgelegt ist, während der linearen Bewegung stationär zu sein.

4. Verschließbarer Elektronikschrank (1) nach einem der Ansprüche 1 bis 3, wobei die zweite Führungsspur (41, 42) dazu ausgelegt ist, sich entlang mit der linearen Bewegung zu bewegen.

5. Verschließbarer Elektronikschrank (1) nach einem der Ansprüche 2 bis 4, wobei der Körper den linearen Bewegungsmechanismus (6) aufweist, der stationäre Rahmen (27, 28) die zweite Führungsspur (29, 30) bereitstellt und mit einem Hauptteil des Körpers (3) verbunden ist und der Bewegungsrahmen (43) die erste Führungsspur (41, 42) bereitstellt und mit der Tür (5) verbunden ist.

6. Verschließbarer Elektronikschrank (1) nach einem der Ansprüche 2 bis 5, wobei eine der ersten Führungsspur (29, 30) und der zweiten Führungsspur (41, 42) linear ist.

7. Verschließbarer Elektronikschrank (1) nach einem der Ansprüche 2 bis 5, wobei die zweite Führungsspur (29, 30) linear ist.

8. Verschließbarer Elektronikschrank (1) nach den Ansprüchen 1 bis 7, wobei die Tangentenrichtung der ersten Führungsspur oder die Tangentenrichtung des vorbestimmten Pfads an unterschiedlichen Positionen entlang der ersten Führungsspur (41, 42, 41') oder dem vorbestimmten Pfad unterschiedlich sind.

9. Verschließbarer Elektronikschrank (1) nach einem der vorhergehenden Ansprüche, wobei die Tür (5) mit einer Vielzahl an Drehgelenken (37, 38) aufgehängt ist, wobei die Gelenke (37, 38) entlang der Schwenkachse aufgereiht sind, wobei die Gelenke (37, 38) dazu ausgelegt sind, sich bei der linearen Bewegung entlang der Tür (37, 38) zu bewegen.

10. Verschließbarer Elektronikschrank (1) nach einem der vorhergehenden Ansprüche, wobei der Körper (3) oder die Tür (5) ein oder mehrere Führungsglieder (15) aufweist und der oder die andere vom Körper (3) bzw. von der anderen Tür (5) ein oder mehrere Eingriffsglieder (59, 60) aufweist, wobei jedes Eingriffsglied (59) mit einem entsprechenden Führungsglied (15) des einen bzw. der mehreren Führungsglieder (15) eingreift, wobei das Führungsglied (15) die Drehung der Tür (5) blockiert und eine Pfad für das Eingriffsglied (59) bereitstellt, wobei der Pfad die lineare Bewegung der Tür (5) bestimmt.

11. Verschließbarer Elektronikschrank (1) nach Anspruch 10, wobei sich das eine oder die mehreren Führungsglieder (15) und die Vielzahl an Gelenken (37, 38) angrenzend an einer gleichen lateralen Seite des Schranks (1) befinden.

12. Verschließbarer Elektronikschrank (1) nach einem der Ansprüche 10 bis 11, wobei der Körper (3) einen Dämpfungsmechanismus (9) aufweist, wobei das Eingriffsglied (59) dazu ausgelegt ist, während zumindest einem Teil der Drehbewegung mit dem Dämpfungsmechanismus (9) einzugreifen, wobei der Dämpfungsmechanismus (9) dazu ausgelegt ist, das Eingriffsglied (59, 60) in das Führungsglied (15) zu führen.

13. Verschließbarer Elektronikschrank (1) nach einem der vorhergehenden Ansprüche, wobei der Elektronikschrank (1) elektromagnetisch abgeschirmt ist.

14. Verschließbarer Elektronikschrank (1) nach einem der vorhergehenden Ansprüche, der eine Dichtung (73) aufweist, die eine Kerbe und eine Kante (31) definiert, wobei sich die Kante (31), wenn die Tür (5) in einer geschlossenen Position (A) ist, an die Führungsspur fügt, wobei eine Schnittstelle zwischen der Tür (5) und dem Körper (3) gebildet wird, wobei es sich bei der Dichtung (73) bevorzugt um eine Beryllium-Dichtung handelt, und wobei sich die Dichtung (73) bevorzugt an der Tür (5) befindet.

## Revendications

1. Armoire électronique verrouillable (1), comprenant un corps (3) et une porte (5), ladite porte (5) étant conçue pour être ouverte en une séquence de mouvement comprenant un premier mouvement linéaire perpendiculaire au plan de la porte et ensuite un mouvement de rotation autour d'un axe de pivotement, ladite armoire (1) comprenant un mécanisme de mouvement linéaire (6), ledit mécanisme de mouvement linéaire (6) comprenant un cadre en mouvement connecté à ladite porte ( 5), un cadre stationnaire connecté à une pièce principale dudit corps (3), une première piste de guidage (41,32) créée par un élément parmi ledit cadre en mouvement et ledit cadre stationnaire, et un système de guidage (29,30) créé par l'autre parmi ledit cadre en mouvement et ledit cadre stationnaire,
**caractérisé en ce que** ladite piste de guidage (41,32) et ledit système de guidage (29,30) sont ainsi mobiles l'un par rapport à l'autre en direction dudit mouvement linéaire, ledit mécanisme de mouvement linéaire (6) comprenant en outre un élément d'entraînement (45, 49, 51) configuré pour entraîner ledit mouvement linéaire en passant le long d'un parcours prédéterminé défini par l'engagement de l'élément d'entraînement dans le système de guidage (29,30) tout en s'engageant simultanément dans ladite piste de guidage (41,42), sachant que, avec un premier emplacement le long dudit parcours prédéterminé correspondant à un second emplacement le long de ladite première piste de guidage de manière à ce que ledit élément d'entraînement (45, 49, 51), tout en passant le long dudit parcours prédéterminé (29,30) à travers ledit premier emplacement, s'engage dans ladite première piste de guidage (41,42) audit second emplacement, une direction tangente dudit premier parcours prédéterminé (29,30) audit premier emplacement étant différente d'une direction tangente de ladite première piste de guidage (41,42) audit second emplacement.

2. Armoire électronique verrouillable (1) selon la revendication 1, ledit système de guidage comprenant une seconde piste de guidage (29,30).

3. Armoire électronique verrouillable (1) selon la revendication 2, ladite seconde piste de guidage (29,30) étant configurée pour être stationnaire pendant ledit mouvement linéaire.

4. Armoire électronique verrouillable (1) selon l'une quelconque des revendications 1 à 3, ladite première piste de guidage (41,42) étant configurée pour se déplacer avec ledit mouvement linéaire.

5. Armoire électronique verrouillable (1) selon l'une quelconque des revendications 2 à 4, ledit corps comprenant ledit mécanisme de mouvement linéaire (6), ledit cadre stationnaire (27,28) créant ladite seconde piste de guidage (29,30) et étant connecté à une pièce principale dudit corps (3), ledit cadre en mouvement (43) créant ladite première piste de guidage (41,42) et étant connecté à ladite porte (5).

6. Armoire électronique verrouillable (1) selon l'une quelconque des revendications 2 à 5, dans laquelle une piste parmi ladite première piste de guidage (29,30) et ladite seconde piste de guidage (41,42) est linéaire.

7. Armoire électronique verrouillable (1) selon l'une quelconque des revendications 2 à 5, dans laquelle ladite seconde piste de guidage (29,30) est linéaire.

8. Armoire électronique verrouillable (1) selon l'une quelconque des revendications 1 à 7, dans laquelle ladite direction tangente de ladite première piste de guidage ou ladite direction tangente dudit parcours prédéterminé est différente à des positions différentes le long de ladite première de guidage (41,42, 41') ou dudit parcours prédéterminé.

9. Armoire électronique verrouillable (1) selon l'une quelconque des revendications précédentes, dans laquelle ladite porte (5) est suspendue par une pluralité d'articulations rotatives (37,38), lesdites articulations (37,38) s'alignant le long dudit axe de pivotement, lesdits articulations (37,38) étant conçues pour se déplacer en même temps que ladite porte (37,38) pendant ledit mouvement linéaire.

10. Armoire électronique verrouillable (1) selon l'une quelconque des revendications précédentes, dans laquelle un élément parmi ledit corps (3) et ladite porte (5) comprend un ou plusieurs éléments de guidage (15) et l'autre parmi ledit corps (3) et ladite porte (5) comprend un ou plusieurs éléments d'engagement (59,60), chaque élément d'engagement (59) s'engageant dans un élément de guidage respectif (15) desdits un ou plusieurs éléments guidage (15), ledit élément de guidage (15) bloquant la rotation de ladite porte (5) et créant un parcours pour ledit élément d'engagement (59), ledit parcours définissant ledit mouvement linéaire de ladite porte (5).

11. Armoire électronique verrouillable (1) selon la revendication 10, dans laquelle lesdits un ou plusieurs éléments de guidage (15) et ladite pluralité d'articulations (37,38) sont situés de manière à être adjacents à une même face latérale de ladite armoire (1).

12. Armoire électronique verrouillable (1) selon l'une quelconque des revendications 10 à 11, dans laquelle ledit corps (3) comprend un mécanisme d'atténuation (9), ledit élément d'engagement (59) étant configuré pour s'engager dans ledit mécanisme d'atténuation (9) pendant au moins une partie dudit mouvement rotationnel, ledit mécanisme d'atténuation (9) étant configuré pour guider ledit élément d'engagement (59,60) dans ledit élément de guidage (15).

13. Armoire électronique verrouillable (1) selon l'une quelconque des revendications précédentes, dans laquelle l'armoire électronique (1) est équipée d'un blindage électromagnétique.

14. Armoire électronique verrouillable (1) selon l'une quelconque des revendications précédentes, comprenant un joint (73) définissant une gorge, et un bord (31), ledit bord (31), ladite porte (5) étant en position fermée (A), correspondant avec ladite piste de guidage en formant une interface entre ladite porte (5) et ledit corps (3), ledit joint (73) étant de préférence un joint en béryllium, et ledit joint (73) se trouvant de préférence sur ladite porte (5).
